# FASCICULE DE BREVET EUROPEEN

(11) **EP 3 623 437 B1**
(45) Date de publication et mention de la délivrance du brevet: **29.12.2021**
(21) Numéro de dépôt: 19197101.9
(22) Date de dépôt: 12.09.2019
(51) Int. Cl.: C09J 5/06, C09J 5/02, B32B 27/04

(54) **PROCÉDÉ DE COLLAGE TEMPORAIRE AVEC ADHESIF THERMOPLASTIQUE INCORPORANT UNE COURONNE RIGIDE**
VORÜBERGEHENDES VERKLEBUNGSVERFAHREN MIT THERMOPLASTISCHEM KLEBER UND INTEGRIERTER STARRER KRONE
METHOD FOR TEMPORARY GLUING WITH THERMOPLASTIC ADHESIVE INCLUDING A RIGID CROWN

(30) Priorité: 14.09.2018 FR 1858323
(43) Date de publication de la demande: 18.03.2020
(73) Titulaire: Commissariat à l'énergie atomique et aux énergies alternatives, 75015 Paris (FR)
(72) Inventeur: MONTMEAT, Pierre, 38054 GRENOBLE CEDEX 09 (FR); FOURNEL, Frank, 38054 GRENOBLE CEDEX 09 (FR); ZUSSY, Marc, 38054 GRENOBLE CEDEX 09 (FR)
(74) Mandataire: Brevalex

(56) Documents cités:
- WO-A1-2016/207702
- US-A1- 2013 302 983
- US-A1- 2014 110 894

## Description

### DOMAINE TECHNIQUE

Le domaine de l'invention est celui de la microélectronique, et plus particulièrement celui des techniques permettant d'élaborer et de manipuler de fines plaques de matériau semi-conducteur.

### ÉTAT DE LA TECHNIQUE ANTÉRIEURE

Dans différents procédés de la microélectronique, il est nécessaire de former et de manipuler des substrats ultra fins, dont l'épaisseur peut notamment être inférieure à 200 micromètres. Or ces substrats ultra fins sont difficiles à manipuler sur les chaines de production avec les outils standards. De plus, selon la nature des matériaux constituant ces substrats ultra fins, ces derniers sont parfois tellement souples qu'ils s'enroulent sur eux-mêmes au repos, rendant leur utilisation délicate.

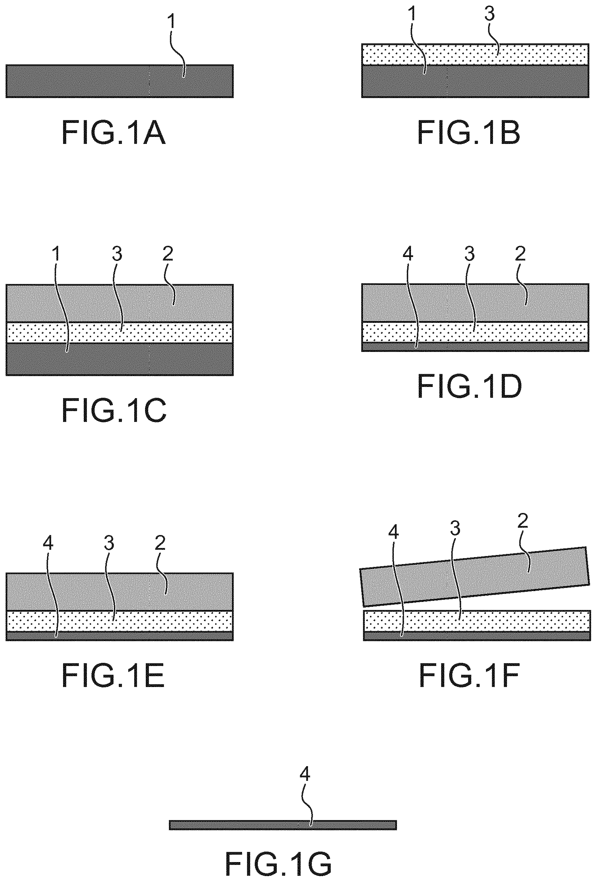

Pour remédier à ces difficultés, et comme représenté sur les figures 1A-1G, une technique de collage temporaire permet de maintenir en place un substrat d'intérêt 1 sur un substrat dit poignée 2 au moyen d'une couche adhésive 3. Une fois le substrat d'intérêt collé au substrat poignée, il peut être aminci à quelques dizaines de micromètres (figure 1D). Le substrat poignée permet de rigidifier le substrat d'intérêt aminci 4, d'autoriser une manipulation avec des outils standards et de réaliser (figure 1E) des étapes technologiques sur le substrat d'intérêt aminci 4 en vue de la fabrication de composants électroniques, telles que des dépôts de différentes couches de matériaux.

Une fois l'amincissement et les étapes technologiques réalisés, le substrat d'intérêt aminci 4 est décollé du substrat poignée (figure 1F). Ce décollement se fait classiquement avec un enchainement d'actions chimiques et mécaniques. Puis un nettoyage (figure 1G) permet de débarrasser le substrat d'intérêt aminci 4 de la couche adhésive 3.

La couche adhésive 3 est généralement réalisée en un polymère qui va notamment englober l'éventuelle topographie des substrats à assembler et permettre d'assembler des substrats présentant une rugosité de surface élevée avec des traitements de préparation de surface et de nettoyage des substrats à assembler moins contraignants et moins coûteux.

Le polymère choisi est par ailleurs généralement un thermoplastique qui, d'une part, va promouvoir l'adhésion sous l'effet d'un traitement à haute température (typiquement inférieure à 150°C), et qui, d'autre part, va faciliter le nettoyage après la séparation d'avec le substrat poignée du fait de sa solubilité.

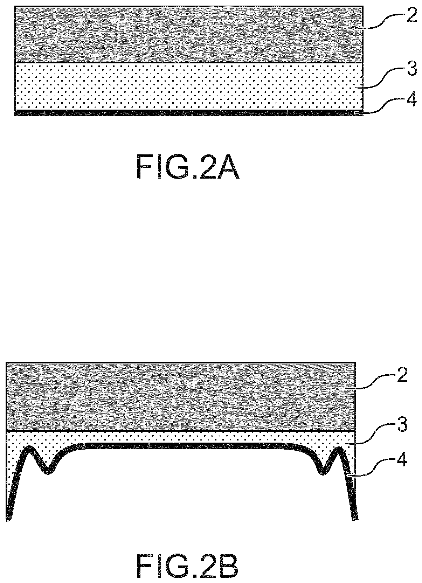

Toutefois, le substrat d'intérêt aminci présente généralement des contraintes mécaniques du fait des différentes couches de matériau déposées à sa surface au cours des étapes technologiques. Or, dès lors que l'assemblage est chauffé au-delà de la température de transition vitreuse du polymère thermoplastique (par exemple au-delà d'environ 100°C pour le polyméthacrylate de méthyle), le polymère devient caoutchouteux et très souple et le substrat d'intérêt aminci va pouvoir relâcher ses contraintes en se déformant. Suite au refroidissement de l'assemblage, cette déformation est conservée. On a ainsi représenté sur les figures 2A et 2B la géométrie de l'assemblage respectivement avant et après un traitement thermique à une température supérieure la température de transition vitreuse du polymère thermoplastique 3.

Une telle déformation est bien entendu gênante pour la suite des étapes technologiques. A titre d'exemples, cette déformation peut rendre impossible un alignement précis en photolithographie ou encore dégrader les performances d'une étape de planarisation par polissage.

### EXPOSÉ DE L'INVENTION

L'invention a pour objectif de proposer une méthode de collage temporaire au moyen d'un adhésif polymère thermoplastique qui permette d'éviter, ou à tout le moins de réduire, une telle déformation du substrat aminci.

L'invention concerne à cet effet un procédé de collage temporaire d'un substrat d'intérêt à un substrat de manipulation, comprenant :
- une étape de réalisation d'un assemblage par mise en contact de faces de collage du substrat d'intérêt et du substrat de manipulation par l'intermédiaire d'un polymère thermoplastique,
- une étape de traitement de l'assemblage à une température de traitement supérieure à la température de transition vitreuse du polymère thermoplastique.

Ce procédé comprend avant l'étape de réalisation de l'assemblage :
- une étape de fabrication, au niveau de la face de collage de l'un des substrats d'intérêt et de manipulation, d'une cavité centrale entourée par une couronne périphérique présentant un niveau supérieur et un niveau inférieur, la couronne périphérique étant en matériau rigide à la température de traitement, et
- une étape de formation d'une couche dudit polymère thermoplastique, ladite couche remplissant la cavité centrale une fois l'assemblage réalisé.

Certains aspects préférés mais non limitatifs de ce procédé sont les suivants :
- l'étape de formation est réalisée de manière à ce qu'une fois l'assemblage réalisé ladite couche s'étende au-dessus du niveau supérieur de la couronne périphérique sur toute la face de collage présentant la cavité centrale et la couronne périphérique ;
- l'étape de fabrication comprend un amincissement d'une partie centrale de l'un des substrats d'intérêt et de manipulation ;
- l'étape de fabrication comprend le dépôt d'un cordon dudit matériau rigide sur une partie périphérique de l'un des substrats d'intérêt et de manipulation ;
- l'étape de fabrication comprend la formation d'une couche dudit matériau rigide sur l'un des substrats d'intérêt et de manipulation et un amincissement d'une partie centrale de la couche dudit matériau rigide ;
- la couronne périphérique présente une largeur qui correspond au moins à 2,5%, de préférence au moins à 5%, du diamètre de la face de collage du substrat d'intérêt.
- le matériau rigide a un module d'Young supérieur à 1 MPa ;
- il comprend en outre une étape de détourage d'une partie périphérique du substrat d'intérêt ;
- il comprend en outre, suite à l'étape de réalisation de l'assemblage, une étape d'amincissement du substrat d'intérêt et une étape de séparation du substrat de manipulation et du substrat de d'intérêt aminci.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels, outre les figures 1A-1G et 2A-2B déjà discutées précédemment :
- les figures 3A-3D représentent différents assemblages temporaires d'un substrat d'intérêt aminci et d'un substrat de manipulation pouvant être réalisés par différentes mises en œuvre de l'invention ;
- les figures 4A-4B, 5A-5B et 6A-6C représentent différentes variantes de réalisation des étapes de fabrication et de formation du procédé selon l'invention ;
- les figures 7A-7E, 8A-8F, 9A-9D, 10A-10D représentent différentes variantes du procédé selon l'invention avec détourage et amincissement du substrat d'intérêt.

### EXPOSÉ DÉTAILLÉ DE MODES DE RÉALISATION PARTICULIERS

L'invention concerne un procédé de collage temporaire d'un substrat d'intérêt à un substrat de manipulation (substrat poignée) qui reprend les étapes discutées précédemment en liaison avec les figures 1A-1G. Notamment, ce procédé comprend une étape de réalisation d'un assemblage par mise en contact de faces de collage du substrat d'intérêt et du substrat de manipulation par l'intermédiaire d'un polymère thermoplastique et application d'un traitement thermique à une température de collage supérieure à la température de transition vitreuse du polymère thermoplastique.

Et ce procédé comprend également la réalisation d'une ou plusieurs étapes technologiques sur l'assemblage, et notamment une étape de traitement de l'assemblage à une température de traitement supérieure à la température de transition vitreuse du polymère thermoplastique. Bien entendu, le procédé selon l'invention peut en outre comprendre, suite à l'étape de réalisation de l'assemblage, une étape d'amincissement du substrat d'intérêt et, après l'étape de traitement de l'assemblage, une étape de séparation du substrat de manipulation et du substrat de d'intérêt aminci.

Comme on l'a vu précédemment, l'étape de traitement à une température de traitement supérieure à la température de transition vitreuse du polymère thermoplastique est susceptible d'engendrer une déformation du substrat d'intérêt aminci. Pour limiter cet effet, l'invention propose d'associer au polymère thermoplastique un second matériau qui conserve une forte rigidité à haute température et plus particulièrement à ladite température de traitement de l'assemblage. En conservant sa rigidité lors de l'étape de traitement de l'assemblage, ce second matériau permet de maintenir le substrat d'intérêt aminci en empêchant sa déformation malgré la forme alors caoutchouteuse du polymère thermoplastique. Par matériau rigide à la température de traitement, on entend typiquement un matériau dont le module d'Young est supérieur à 1 MPa.

Pour ce faire, le procédé selon l'invention comprend plus particulièrement, avant l'étape de réalisation de l'assemblage, une étape de fabrication, au niveau de la face de collage de l'un des substrats d'intérêt et de manipulation, d'une cavité centrale entourée par une couronne périphérique présentant un niveau supérieur et un niveau inférieur, la couronne périphérique étant en un matériau rigide à la température de traitement. La couronne périphérique peut être agencée en bord de plaque (i.e. sur le pourtour de la face de collage sur laquelle elle est formée) ou être déportée du bord de plaque d'une distance correspondant à un détourage du substrat d'intérêt pour in fine se retrouver au niveau du pourtour du substrat d'intérêt détouré.

Le procédé selon l'invention comprend également une étape de formation d'une couche dudit polymère thermoplastique qui vient remplir la cavité centrale.

Dans un mode de réalisation possible, l'étape de formation est réalisée de manière à ce que ladite couche remplisse la cavité centrale et s'étende, sur la face de collage présentant la cavité centrale et la couronne périphérique, au-dessus du niveau supérieur de la couronne périphérique sur toute la face de collage présentant la cavité centrale et la couronne périphérique.

Dans un autre mode de réalisation, l'étape de formation est réalisée de manière à ce que ladite couche ne remplisse que la cavité centrale et le procédé comprend la formation d'une couche en ledit polymère sur la face de collage de l'autre substrat.

Dans l'un ou l'autre de ces modes de réalisation, le collage est intégralement assuré par le polymère thermoplastique, et ce y compris pour le collage de la couronne périphérique. A l'aplomb de la couronne périphérique rigide, l'épaisseur du polymère thermoplastique est néanmoins réduite ce qui fait qu'à haute température, notamment à la température de traitement supérieure à la température de transition vitreuse du polymère thermoplastique, la déformation du substrat d'intérêt aminci est fortement limitée.

La couronne périphérique en matériau rigide présente une largeur qui correspond au moins à 2,5%, de préférence au moins à 5%, du diamètre de la face de collage du substrat d'intérêt (le cas échéant son diamètre après détourage). De telle manière, les forces de pelage qui risquent de déformer le substrat d'intérêt aminci sont contenues. À titre d'exemple, la couronne périphérique peut être formée sur un substrat de 200mm de diamètre et présenter une largeur de 5mm à 10mm.

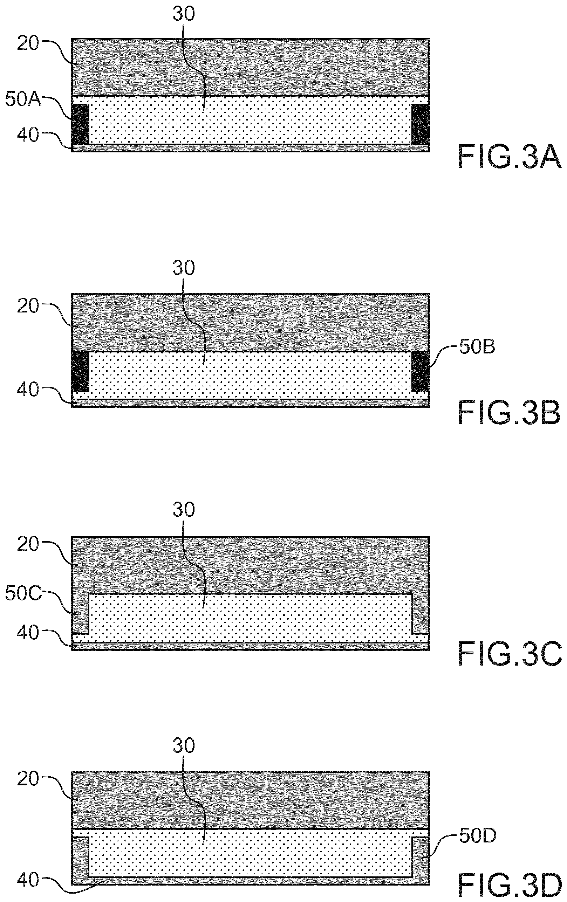

Dans l'un ou l'autre des modes de réalisation décrits ci-dessus, le procédé permet de fournir, après assemblage des substrats et amincissement du substrat d'intérêt, les assemblages représentés sur les figures 3A-3D du substrat poignée 20 avec le substrat d'intérêt aminci 40 par l'intermédiaire du polymère thermoplastique 30 dans lequel on retrouve la couronne périphérique 50A-50D en matériau rigide. Sur ces figures 3A-3D, la couronne périphérique 50A-50D est agencée en bord de plaque.

Sur les figures 3A et 3D, la couronne périphérique 50A, 50D est formée sur la face de collage du substrat d'intérêt. Elle peut être rapportée sur cette face de collage (figure 3A) et ainsi ne pas être nécessairement réalisée en un matériau identique à celui du substrat d'intérêt, ou être issue d'une structuration de cette face de collage (figure 3D) et être ainsi réalisée dans le même matériau que le substrat d'intérêt

Sur les figures 3B et 3C, la couronne périphérique 50B, 50C est formée sur la face de collage du substrat de manipulation 20. Elle peut être rapportée sur cette face de collage (figure 3B) et ainsi ne pas nécessairement être réalisée en un matériau identique à celui du substrat de manipulation, ou être issue d'une structuration de cette face de collage (figure 3C) et être ainsi réalisée dans le même matériau que le substrat de manipulation.

Lorsque le matériau rigide n'est pas en un matériau identique à celui du substrat d'intérêt ou du substrat de manipulation (figures 3A et 3B), le matériau rigide peut avantageusement être contraint afin de limiter l'impact des contraintes du substrat d'intérêt aminci. En effet, si le substrat d'intérêt aminci présente des contraintes, la structure finale peut présenter une flèche importante. Avec une couronne possédant une contrainte opposée, la flèche globale de la structure peut être minimisée, voire annulée.

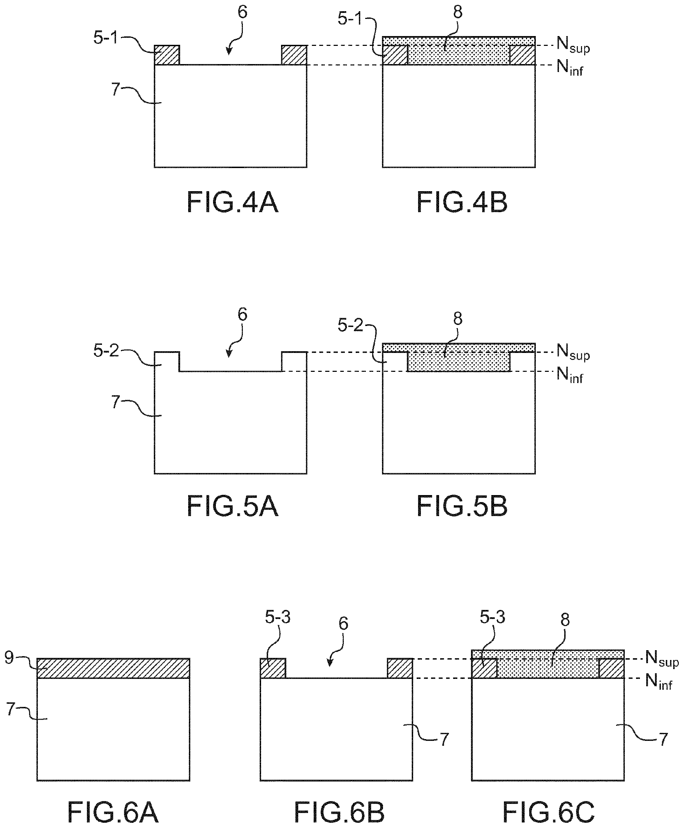

On a représenté sur les figures 4A-4B, 5A-5B et 6A-6C différents modes de réalisation possibles de l'étape de fabrication de la cavité centrale et de la couronne périphérique sur la face de collage de l'un des substrats d'intérêt et de manipulation et de l'étape de formation de la couche de collage en polymère thermoplastique.

Comme représenté sur la figure 4A, l'étape de fabrication peut comprendre le dépôt d'un cordon dudit matériau rigide sur une partie périphérique de l'un des substrats d'intérêt et de manipulation. Ce cordon forme sur la face de collage du substrat 7 une couronne périphérique 5-1 délimitant une cavité centrale 6. La couronne périphérique présente un niveau inférieur Ninf correspond au fond de la cavité centrale et un niveau supérieur NSup. Et comme représenté sur la figure 4B, l'étape de formation est réalisée de manière à ce que la couche de collage 8 remplisse la cavité centrale et s'étende au-dessus du niveau supérieur Nsup de la couronne périphérique 5-1 sur toute la face de collage présentant la cavité centrale et la couronne périphérique.

Comme représenté sur la figure 5A, l'étape de fabrication peut comprendre un amincissement d'une partie centrale de l'un des substrats d'intérêt et de manipulation, par exemple selon le procédé Taiko. Cet amincissement forme, sur la face de collage du substrat 7, la cavité centrale 6 entourée de la couronne périphérique 5-2. La couronne périphérique présente un niveau inférieur Ninf correspond au fond de la cavité centrale et un niveau supérieur NSup. Et comme représenté sur la figure 5B, l'étape de formation est réalisée de manière à ce que la couche de collage 8 remplisse la cavité centrale et s'étende au-dessus du niveau supérieur Nsup de la couronne périphérique 5-2 sur toute la face de collage présentant la cavité centrale et la couronne périphérique.

Comme représenté sur les figures 6A et 6B, l'étape de fabrication peut comprendre la formation d'une couche 9 dudit matériau rigide sur l'un des substrats d'intérêt et de manipulation et un amincissement d'une partie centrale de la couche dudit matériau rigide, par exemple selon le procédé Taiko ou au moyen d'une photolithographie et d'une gravure ionique. Cet amincissement forme, sur la face de collage du substrat 7, la cavité centrale 6 entourée de la couronne périphérique 5-3. La couronne périphérique présente un niveau inférieur Ninf correspond au fond de la cavité centrale et un niveau supérieur NSup. Et comme représenté sur la figure 6C, l'étape de formation est réalisée de manière à ce que la couche de collage 8 remplisse la cavité centrale et s'étende au-dessus du niveau supérieur Nsup de la couronne périphérique 5-3 sur toute la face de collage présentant la cavité centrale et la couronne périphérique.

Dans une variante de réalisation de l'invention, le procédé comprend en outre une étape de détourage d'une partie périphérique du substrat d'intérêt réalisée avant ou après l'étape d'assemblage. L'objectif de ce détourage est d'enlever une importante épaisseur de la périphérie du substrat d'intérêt (de l'ordre de 100µm pour un substrat de 725µm d'épaisseur par exemple). Une telle élimination permet d'éviter que le polymère ne déborde dans la machine de collage. Elle permet également d'avoir, après amincissement du substrat d'intérêt, un substrat d'intérêt aminci moins fragile dont les bords sont bien nets, bien définis et pas trop près du bord de la structure.

D'une manière générale, ce détourage réduit le diamètre de la face de collage de 2 à 10mm. Bien évidement si un tel détourage du substrat d'intérêt est réalisé, la couronne de l'invention doit être agencée en bord de plaque en étant plus large que la réduction opérée par le détourage, ou être déportée du bord de plaque d'une distance correspondant à la réduction opérée par le détourage pour *in fine* se retrouver au niveau du pourtour du substrat d'intérêt détouré.

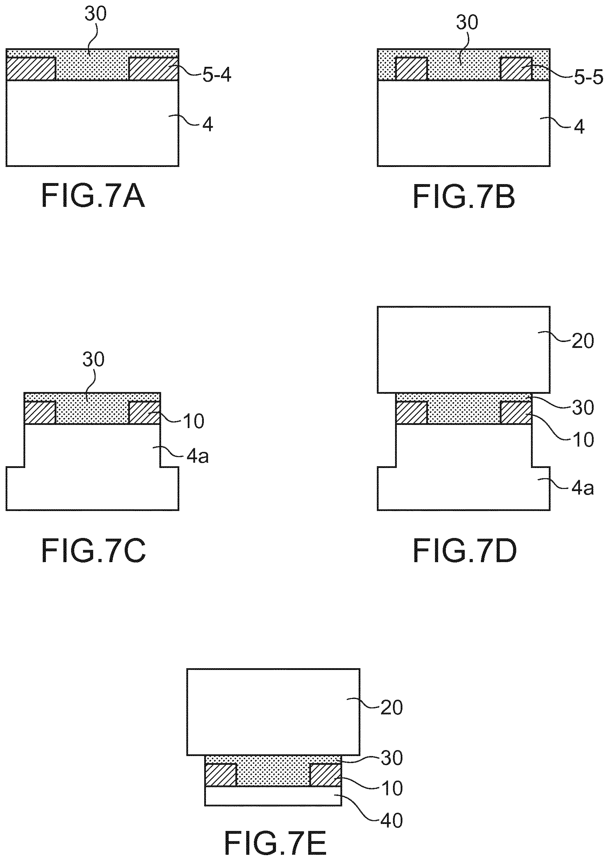

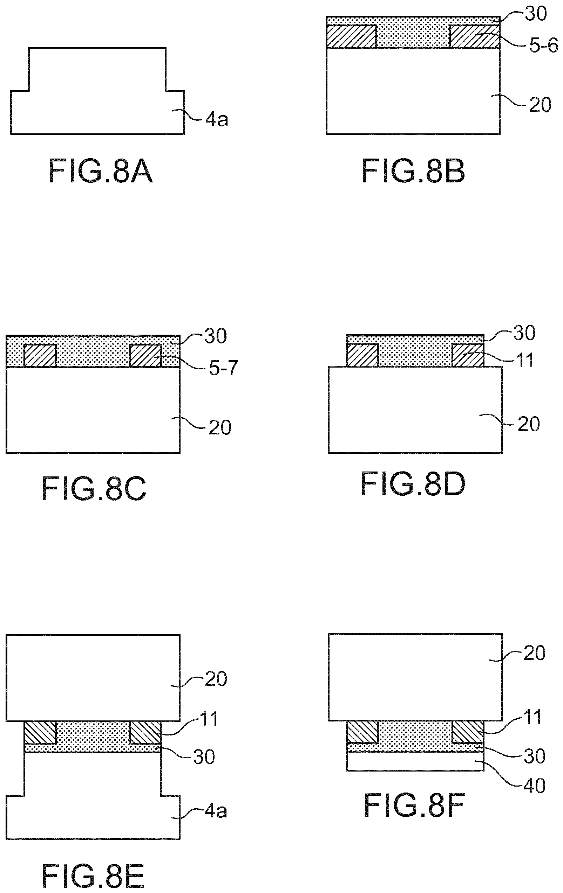

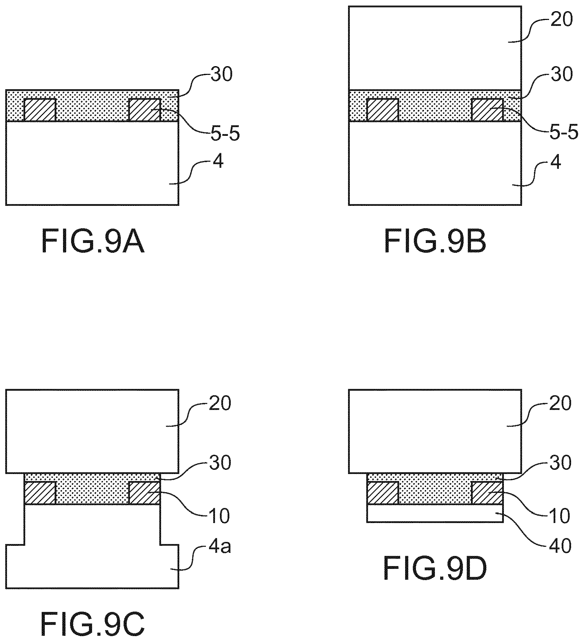

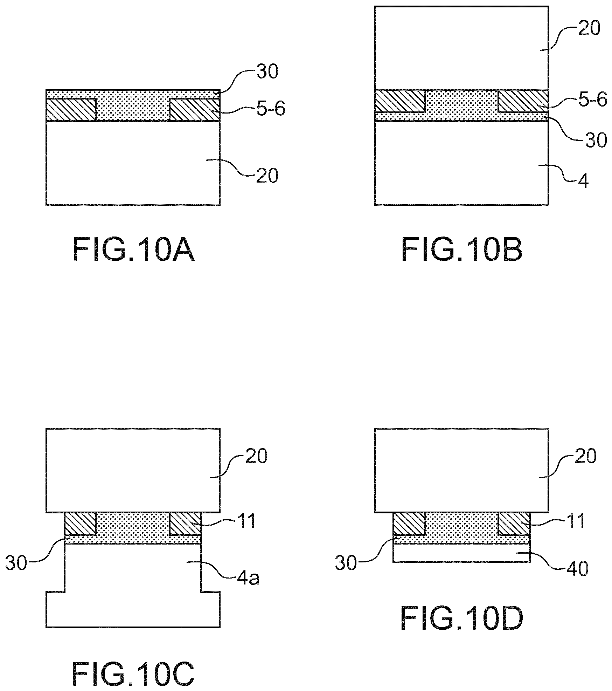

On a représenté sur les figures 7A-7E, 8A-8F, 9A-9D, 10A-10D différentes variantes du procédé selon l'invention avec détourage et amincissement du substrat d'intérêt. Sur les figures 7A-7E et 8A-8F, le détourage est réalisé avant l'assemblage alors que sur les figures 9A-9D et 10A-10D, le détourage est réalisé après l'assemblage.

Dans le procédé illustré par les figures 7A-7E, la couronne périphérique est réalisée au niveau de la face de collage du substrat d'intérêt 4. Il s'agit d'une couronne 5-4 en bord de plaque plus large que la réduction opérée par le détourage (figure 7A) ou d'une couronne 5-5 déportée du bord de plaque d'une distance correspondant la réduction opérée par le détourage (figure 7B). L'opération de détourage est ensuite réalisée qui fournit un substrat d'intérêt détouré 4a avec le matériau rigide de la couronne 10 présent au niveau du pourtour de la face de collage du substrat d'intérêt détouré 4a (figure 7C). Puis on procède à l'assemblage avec le substrat de manipulation 20 (figure 7D) via la couche de polymère thermoplastique 30, et à l'amincissement pour obtenir le substrat d'intérêt aminci 40 (figure 7E).

Dans le procédé illustré par les figures 8A-8F, on procède à la fourniture d'un substrat d'intérêt détouré 4a (figure 8A). La couronne périphérique est réalisée au niveau de la face de collage du substrat de manipulation 20. Il s'agit d'une couronne 5-6 en bord de plaque plus large que la réduction opérée par le détourage (figure 8B) ou d'une couronne 5-7 déportée du bord de plaque d'une distance correspondant la réduction opérée par le détourage (figure 8C). Une partie périphérique de la couche de collage est éliminée sur une distance correspondant au détourage pour venir faire affleurer le matériau rigide de la couronne 11 (figure 8D). Puis on procède à l'assemblage avec le substrat d'intérêt détouré 4a via la couche polymère thermoplastique 30, le matériau rigide de la couronne 11 étant présent au niveau du pourtour de la face de collage du substrat d'intérêt détouré 4a (figure 8E), et à l'amincissement pour obtenir le substrat d'intérêt aminci 40 (figure 8F).

Dans le procédé illustré par les figures 9A-9D, la couronne périphérique est réalisée au niveau de la face de collage du substrat d'intérêt 4. Il s'agit d'une couronne 5-5 déportée du bord de plaque d'une distance correspondant la réduction opérée par le détourage (figure 9A). Bien entendu, il pourrait s'agir d'une couronne en bord de plaque plus large que la réduction opérée par le détourage. L'assemblage avec le substrat de manipulation 20 est ensuite réalisé via la couche polymère thermoplastique 30 (figure 9B) avant une opération de détourage qui fournit un substrat d'intérêt détouré 4a avec le matériau rigide de la couronne 10 présent au niveau du pourtour de la face de collage du substrat d'intérêt détouré 4a (figure 9C). Puis on procède à l'amincissement pour obtenir le substrat d'intérêt aminci 40 (figure 9D).

Dans le procédé illustré par les figures 10A-10D, la couronne périphérique est réalisée au niveau de la face de collage du substrat de manipulation 20. Il s'agit d'une couronne 5-6 en bord de plaque plus large que la réduction opérée par le détourage (figure 10A). Bien entendu il pourrait également s'agir d'une couronne déportée du bord de plaque d'une distance correspondant la réduction opérée par le détourage. L'assemblage avec le substrat d'intérêt 4 est ensuite réalisé via la couche polymère thermoplastique 30 (figure 10B) avant une opération de détourage qui fournit un substrat d'intérêt détouré 4a avec le matériau rigide de la couronne 11 présent au niveau du pourtour de la face de collage du substrat d'intérêt détouré 4a (figure 10C). Puis on procède à l'amincissement pour obtenir le substrat d'intérêt aminci 40 (figure 10D).

On présente dans ce qui suit différents exemples de réalisation de l'invention. Dans chacun de ces exemples, l'adhésif polymère thermoplastique est le polymère commercialisé par la société Brewer Science sous le nom commercial BrewerBOND^{®}305-30.

Un premier exemple de réalisation est conforme au procédé illustré aux figures 4A et 4B. Un cordon d'un polymère réticulé dont la rigidité varie peu en fonction de la température, par exemple le polymère SINR-3110 commercialisé par la société Shin Etsu Chemical, est déposé sur la périphérie d'un substrat d'intérêt en silicium. Le cordon présente une largeur de 5 mm et une hauteur de 20 µm. On vient ensuite déposer 25 µm de l'adhésif thermoplastique sur le substrat d'intérêt. On dépose une couche antiadhésive, typiquement une couche en matériau fluoré, par exemple le matériau 3M^{™}Novec^{™}2702, à la surface d'un substrat de manipulation de silicium. Les deux substrats sont assemblés à 200 °C, sous vide et avec une force de 6 kN. Le substrat d'intérêt est aminci à 100 µm par abrasion au moyen d'une roue diamantée.

Un second exemple de réalisation est conforme au procédé illustré aux figures 5A et 5B. Un substrat d'intérêt en silicium est traité au moyen du procédé TAIKO pour y former une cavité centrale d'une profondeur de 30 µm entourée d'une couronne périphérique de 5mm de large. On vient ensuite déposer 35 µm de l'adhésif thermoplastique sur le substrat d'intérêt. On dépose une couche antiadhésive, typiquement une couche en matériau fluoré, par exemple le matériau 3M^{™}Novec^{™}2702, à la surface d'un substrat de manipulation de silicium. Les deux substrats sont assemblés à 200 °C, sous vide et avec une force de 6 kN. Le substrat d'intérêt est aminci à 80 µm par abrasion au moyen d'une roue diamantée. Le procédé TAIKO permet d'adapter facilement la géométrie de la cavité centrale et de la couronne périphérique : la cavité centrale peut avoir une profondeur de 5 µm à plusieurs centaines de micromètres et la couronne périphérique peut avoir une largeur de 5 mm à plusieurs dizaines de millimètres.

Un troisième exemple de réalisation est conforme au procédé illustré aux figures 6A à 6C. On vient coller une plaque de silice fondue sur un substrat d'intérêt en silicium. La plaque de silice fondue est amincie par meulage pour former une couche de 30 µm d'épaisseur. Cette couche est traitée au moyen du procédé TAIKO pour y former une cavité centrale d'une profondeur de 30 µm entourée d'une couronne périphérique de 5mm de large. On vient ensuite déposer 35 µm de l'adhésif thermoplastique sur le substrat d'intérêt. On dépose une couche antiadhésive, typiquement une couche en matériau fluoré, par exemple le matériau 3M^{™}Novec^{™}2702, à la surface d'un substrat de manipulation de silicium. Les deux substrats sont assemblés à 200 °C, sous vide et avec une force de 6 kN. Le substrat d'intérêt est aminci à 80 µm par abrasion au moyen d'une roue diamantée. Lors de traitements thermiques avant le démontage final, la couronne de silice fondue est en tension et permet ainsi de limiter les déformations induites par d'éventuelles contraintes dans le substrat d'intérêt aminci.

Un quatrième exemple de réalisation est conforme au procédé illustré aux figures 6A à 6C. On vient coller un substrat en silicium sur un substrat d'intérêt en silicium, les deux substrats présentant des températures différentes au moment du collage : 25°C et 100°C. La plaque de silicium qui était à 100°C au moment du collage est amincie par meulage pour former une couche de 30 µm d'épaisseur. Cette couche est traitée au moyen du procédé TAIKO pour y former une cavité centrale d'une profondeur de 30 µm entourée d'une couronne périphérique de 5mm de large. On vient ensuite déposer 35 µm de l'adhésif thermoplastique sur le substrat d'intérêt. On dépose une couche antiadhésive, typiquement une couche en matériau fluoré, par exemple le matériau 3M^{™}Novec^{™}2702, à la surface d'un substrat de manipulation de silicium. Les deux substrats sont assemblés à 200 °C, sous vide et avec une force de 6 kN. Le substrat d'intérêt est aminci à 80 µm par abrasion au moyen d'une roue diamantée. Lors de traitements thermique avant le démontage final, la couronne de silicium est en tension et permet ainsi de limiter les déformations induites par d'éventuelles contraintes dans le substrat d'intérêt aminci.

Dans un cinquième exemple de réalisation, on réalise au moyen du procédé TAIKO dans un substrat de manipulation en silicium une cavité centrale de 30 µm de profondeur et une couronne périphérique de 5mm de large. On vient ensuite déposer 35 µm de l'adhésif thermoplastique sur le substrat de manipulation. On dépose une couche antiadhésive, typiquement une couche en matériau fluoré, par exemple le matériau 3M^{™}Novec^{™}2702, à la surface du substrat d'intérêt. Les deux substrats sont assemblés à 200 °C, sous vide et avec une force de 6 kN. Le substrat d'intérêt est aminci à 150 µm par abrasion au moyen d'une roue diamantée.

## Revendications

1. Procédé de collage temporaire d'un substrat d'intérêt (40) à un substrat de manipulation (20), comprenant :
une étape de réalisation d'un assemblage par mise en contact de faces de collage du substrat d'intérêt et du substrat de manipulation par l'intermédiaire d'un polymère thermoplastique (30),
une étape de traitement de l'assemblage à une température de traitement supérieure à la température de transition vitreuse du polymère thermoplastique, **caractérisé en ce qu'**il comprend avant l'étape de réalisation de l'assemblage :
une étape de fabrication, au niveau de la face de collage de l'un des substrats d'intérêt et de manipulation, d'une cavité centrale entourée par une couronne périphérique (50A-50D) présentant un niveau supérieur et un niveau inférieur, la couronne périphérique étant en matériau rigide à la température de traitement, et
une étape de formation d'une couche dudit polymère thermoplastique (30), ladite couche remplissant la cavité centrale une fois l'assemblage réalisé.

2. Procédé selon la revendication 1, dans lequel l'étape de formation est réalisée de manière à ce qu'une fois l'assemblage réalisé ladite couche s'étende au-dessus du niveau supérieur de la couronne périphérique sur toute la face de collage présentant la cavité centrale et la couronne périphérique.

3. Procédé selon l'une des revendications 1 et 2, dans lequel l'étape de fabrication comprend un amincissement d'une partie centrale de l'un des substrats d'intérêt et de manipulation.

4. Procédé selon l'une des revendications 1 et 2, dans lequel l'étape de fabrication comprend le dépôt d'un cordon (5-1) dudit matériau rigide sur une partie périphérique de l'un des substrats d'intérêt et de manipulation.

5. Procédé selon l'une des revendications 1 et 2, dans lequel l'étape de fabrication comprend la formation d'une couche (9) dudit matériau rigide sur l'un des substrats d'intérêt et de manipulation et un amincissement d'une partie centrale de la couche dudit matériau rigide.

6. Procédé selon l'une des revendications 1 à 5, dans lequel la couronne périphérique présente une largeur qui correspond au moins à 2,5%, de préférence au moins à 5%, du diamètre de la face de collage du substrat d'intérêt.

7. Procédé selon l'une des revendications 1 à 6, dans lequel le matériau rigide a un module d'Young supérieur à 1 MPa.

8. Procédé selon l'une des revendications 1 à 7, comprenant en outre une étape de détourage d'une partie périphérique du substrat d'intérêt.

9. Procédé selon l'une des revendications 1 à 8, comprenant en outre, suite à l'étape de réalisation de l'assemblage, une étape d'amincissement du substrat d'intérêt et une étape de séparation du substrat de manipulation et du substrat de d'intérêt aminci.

## Patentansprüche

1. Verfahren zum temporären Kleben eines interessierenden Substrats (40) an ein Handhabungssubstrat (20), umfassend:
einen Schritt des Realisierens einer Anordnung durch Inkontaktbringen von Klebeflächen des interessierenden Substrats und des Handhabungssubstrats mittels eines thermoplastischen Polymers (30),
einen Schritt des Behandelns der Anordnung bei einer Behandlungstemperatur oberhalb der Glasübergangstemperatur des thermoplastischen Polymers,
**dadurch gekennzeichnet, dass** es vor dem Schritt des Realisierens der Anordnung umfasst:
einen Schritt des Herstellens, im Bereich der Klebefläche des interessierenden Substrats oder des Handhabungssubstrats, eines zentralen Hohlraums, der durch eine periphere Krone (50A-50D) umgeben ist, die ein oberes Niveau und ein unteres Niveau aufweist, wobei die periphere Krone aus einem Material ist, das bei der Behandlungstemperatur fest ist, und
einen Schritt des Bildens einer Schicht aus dem thermoplastischen Polymer (30), wobei die Schicht den zentralen Hohlraum füllt, wenn die Anordnung realisiert ist.

2. Verfahren nach Anspruch 1, bei dem der Schritt des Bildens derart realisiert wird, dass sich die Schicht, sobald die Anordnung realisiert ist, über dem oberen Niveau der peripheren Krone über die gesamte Klebefläche erstreckt, die den zentralen Hohlraum und die periphere Krone aufweist.

3. Verfahren nach einem der Ansprüche 1 und 2, bei dem der Schritt des Herstellens ein Abdünnen eines zentralen Teils des interessierenden Substrats oder des Handhabungssubstrats umfasst.

4. Verfahren nach einem der Ansprüche 1 und 2, bei dem der Schritt des Herstellens das Aufbringen eines Bands (5-1) aus dem festen Material auf einem peripheren Teil des interessierenden Substrats oder des Handhabungssubstrats umfasst.

5. Verfahren nach einem der Ansprüche 1 und 2, bei dem der Schritt des Herstellens das Bilden einer Schicht (9) aus dem festen Material auf dem interessierenden Substrat oder dem Handhabungssubstrat und ein Abdünnen eines zentralen Teils der Schicht aus dem festen Material umfasst.

6. Verfahren nach einem der Ansprüche 1 bis 5, bei dem die periphere Krone eine Breite aufweist, die wenigstens 2,5%, vorzugsweise wenigstens 5% des Durchmessers der Klebefläche des interessierenden Substrats entspricht.

7. Verfahren nach einem der Ansprüche 1 bis 6, bei dem das feste Material ein Young-Modul größer als 1 MPa hat.

8. Verfahren nach einem der Ansprüche 1 bis 7, ferner umfassend einen Schritt des Zuschneidens eines peripheren Teils des interessierenden Substrats.

9. Verfahren nach einem der Ansprüche 1 bis 8, ferner umfassend im Anschluss an den Schritt des Realisierens der Anordnung einen Schritt des Abdünnens des interessierenden Substrats und einen Schritt des Separierens des Handhabungssubstrats und des abgedünnten interessierenden Substrats.

## Claims

1. Method for the temporary bonding of a substrate of interest (40) to a handle substrate (20), comprising:
a step of forming an assembly by placing bonding faces of the substrate of interest and of the handle substrate into contact with one another via a thermoplastic polymer (30),
a step of treating the assembly at a treatment temperature that exceeds the glass transition temperature of the thermoplastic polymer,
**characterised in that** it comprises, prior to the assembly forming step:
a step of producing, at the bonding face of one of either the substrate of interest or the handle substrate, a central cavity surrounded by a peripheral ring (50A-50D) having an upper level and a lower level, the peripheral ring being made of a material that is rigid at the treatment temperature, and
a step of forming a layer of said thermoplastic polymer (30), said layer filling the central cavity once the assembly has been formed.

2. Method according to claim 1, wherein the step of producing is carried out such that, once the assembly has been formed, said layer extends above the upper level of the peripheral ring over the entire bonding face having the central cavity and the peripheral ring.

3. Method according to one of claims 1 and 2, wherein the step of producing comprises thinning of a central part of one of either the substrate of interest or the handle substrate.

4. Method according to one of claims 1 and 2, wherein the step of producing comprises depositing a band (5-1) of said rigid material on a peripheral part of one of either the substrate of interest or the handle substrate.

5. Method according to one of claims 1 and 2, wherein the step of producing comprises the formation of a layer (9) of said rigid material on one of either the substrate of interest or the handle substrate and a thinning of a central part of the layer of said rigid material.

6. Method according to one of claims 1 to 5, wherein the peripheral ring has a width that corresponds to at least 2.5%, preferably at least 5%, of the diameter of the bonding face of the substrate of interest.

7. Method according to one of claims 1 to 6, wherein the rigid material has a Young's modulus greater than 1 MPa.

8. Method according to one of claims 1 to 7, further comprising a step of trimming a peripheral part of the substrate of interest.

9. Method according to one of claims 1 to 8, further comprising, after the assembly forming step, a step of thinning the substrate of interest and a step of separating the handle substrate from the thinned substrate of interest.
